# EUROPEAN PATENT APPLICATION

(11) **EP 3 413 357 A1**
(43) Date of publication of application: **12.12.2018**
(21) Application number: 17746942.6
(22) Date of filing: 25.01.2017
(51) Int. Cl.: H01L 31/048, H01L 31/18

(54) **HIGH-CONDUCTIVITY AND HIGH-VOLTAGE SOLAR PHOTOVOLTAIC GLASS PANEL**

(30) Priority: 03.02.2016 CN 201610076702
(71) Applicant: Wuhan Huashang Green Technology Co., Ltd., Wuhan, Hubei 430000 (CN)
(72) Inventor: LIU, Lianjia, Jinan Shandong 250031 (CN); GAI, Qingliang, Binzhou Shandong 256599 (CN); YOU, Xiaojiang, Wuhan Hubei 430015 (CN)
(74) Representative: dompatent von Kreisler Selting Werner - Partnerschaft von Patent- und Rechtsanwälten mbB
(86) International application number: PCT/CN2017/072632
(87) International publication number: WO 2017/133622

(57) **Abstract**

A high-conductivity and high-voltage solar photovoltaic glass panel includes two glass substrates (1). A surface of each of the two glass substrates (1) faces air. A conductive paste, printed on the surface of the glass substrate (1), is baked, heated, and cooled to form a conductive circuit (2) fused with the surface of the glass substrate (1). A solar chip (7) with two electrodes, respectively located on both sides of the solar chip (7), is clamped between the two glass substrates (1), and the two electrodes of the solar chip (7) are respectively connected with two solder pads (3) of the two conductive circuits (2) of the two glass substrates (1) through two tin layers (4). A sealant (8) is placed between the edges of the two glass substrates (1). The glass substrate (1) is a glass-tempered substrate, and a surface of the conductive circuit (2), except a region reserved for a solder pad (3) used for welding the solar chip (7), is covered with a printed-circuit-board (PCB) organic solder-resistant layer. The high-conductivity and high-voltage solar photovoltaic glass panel has the characteristics of high-conductivity and high light transmittance and has the characteristic of good thermal conductivity in high-power applications. The high-conductivity and high-voltage solar photovoltaic glass panel can be applied to the use of large-area light transmission, such as t the agricultural shed roofs.

## Description

### TECHNICAL FIELD

The present invention relates to a high-conductivity and high-voltage solar photovoltaic glass panel, and more particularly to a high-conductivity and high-voltage solar photovoltaic glass panel, which belongs to the field of electronic devices.

### BACKGROUND ART

As one of the national key industries, the electronic industry has been rapidly developed in recent years, especially in the terminal products with light, thin, short and small development trends. For a printed circuit board industry, which is a basic of the electronic industry, the higher demands (e.g. high density, small size and high electrical conductivity) has been requested. under such circumstances, the technology of the printed circuit board has been developed rapidly, and each industry of weak electricity (e.g. computer and peripheral auxiliary system, medical equipment, mobile phone, digital camera, communication equipment, precision instrument, and aerospace) has put forward many specific and clear technical specifications for the process and quality of the printed circuit boards.

At first, it is to form electrodes on a solar chip in a solar photovoltaic glass panel of the prior art, wherein a positive electrode and a negative electrode may be located on the same side of the solar chip or on the both sides of the solar chip. In general, the positive electrode and the negative electrode are located on the same side of the solar chip in the solar photovoltaic glass panel of the prior art. The solar chip is a crystalline silicon, which is very thin and brittle. it is necessary to use a bump welding process to weld the solar chip, having the electrodes, on a bottom plate through a set of copper strips. The bottom plate has bearing capacity and has a conductive circuit. Finally, a solar cell module is installed on a glass plate by a lamination process, wherein the glass plate mainly has the functions of isolation and protection.

Because the solar photovoltaic glass panel needs to withstand large current and high voltage, it needs to have very strong conductive capability. However, a conduction rate of the bottom plate, having the conductive circuit, is insufficient in the solar photovoltaic glass panel of the prior art, so as to make a conduction rate of a solar photovoltaic glass plate very insufficient. Meanwhile, the bump welding process makes the interconnectivity between the conductive circuits very strong, and only one side is covered with the glass plate, and the solar chip is installed and borne on the glass plate. Once the solar photovoltaic glass plate is broken or there is a problem with the conductive circuit, it is easy to cause a short circuit. There is a great safety hazard, and it is difficult to pass the 3C safety certification. The bump welding machine is expensive and inefficient. In addition, the solar photovoltaic glass plate of the prior art is opaque and is very limited in its applications.

### DESCRIPTION OF THE INVENTION

For solving the above problems of the prior art, the present invention is to provide a high-conductivity and high-voltage solar photovoltaic glass panel. The high-conductivity and high-voltage solar photovoltaic glass panel has light transmittance of more than 90% and has the characteristic of superconductivity, wherein the electrical impedance of a conductive circuit of a highly conductive transparent glass-based circuit board is lower than 5×10⁻⁸ Ω. The conductive circuit is bonding to a glass substrate without any bonding medium so that the conductive circuit has the characteristic of good thermal conductivity in high-power applications. The conductive circuit is tightly fused with surface molecules of the glass substrate, wherein a solar chip can be bonded on the conductive circuit and the solar chip is not easily peeled off. The high-conductivity and high-voltage solar photovoltaic glass panel has the characteristics of high-conductivity and high light transmittance. The high-conductivity and high-voltage solar photovoltaic glass panel can be used in high-power and high-voltage applications.

For solving the above problems of the prior art, the present invention is to provide a high-conductivity and high-voltage solar photovoltaic glass panel. The high-conductivity and high-voltage solar photovoltaic glass panel includes two glass substrates. A surface of each of the two glass substrates faces air. A conductive paste, printed on the surface of the glass substrate, is baked, heated, and cooled to form a conductive circuit fused with the surface of the glass substrate. The conductive circuit is made essentially of a graphene layer or a conductive layer having a graphene upper portion and a metal lower portion fused with the glass substrate, and a surface of the graphene upper portion is fused with a surface of the metal lower portion. A solar chip with two electrodes, respectively located on both sides of the solar chip, is clamped between the two glass substrates, and the two electrodes of the solar chip are respectively connected with two solder pads of the two conductive circuits of the two glass substrates through two tin layers. A sealant is placed between the edges of the two glass substrates. The glass substrate is a glass-tempered substrate, and a surface of the conductive circuit, except a region reserved for a solder pad used for welding the solar chip, is covered with a printed-circuit-board (PCB) organic solder-resistant layer.

The surface of the glass substrate and an upper surface of the conductive circuit are at the same level.

A gap between the two glass substrates is less than 2 mm.

The conductive paste includes conductive powder, low temperature glass powder, ethyl cellulose, terpineol, and dibutyl maleate. A mass ratio of conductive powder : low temperature glass powder : ethyl cellulose : terpineol: dibutyl maleate is 65 to 75 : 3 : 5 to 10 : 10 to 20 : 1 to 3. The conductive powder is graphene powder or a mixture of metal powder and graphene powder. When the conductive powder is the mixture of metal powder and graphene powder, the graphene powder accounts for 2% to 5% by mass of the conductive paste.

The surface of the glass substrate faces air, and the conductive paste, printed on the surface of the glass substrate, is baked at a temperature between 120 and 150 °C for 100 to 200 seconds, placed at a temperature between 550 and 600 °C for 300 to 360 seconds, then placed at a temperature between 710 and 730 °C for 120 to 220 seconds, and finally cooled to form the conductive circuit fused with the surface of the glass substrate.

The high-conductivity and high-voltage solar photovoltaic glass panel of the present invention has the advantages described as follows:
(1) The conductive circuit is tightly fused with the glass substrate. It is a fusional relation between the conductive circuit and the glass substrate. A highly conductive transparent glass-based circuit board has the characteristic of superconductivity, wherein the electrical impedance of the conductive circuit of the highly conductive transparent glass-based circuit board is lower than 5×10⁻⁸ Ω. The solar chip is combined with the conductive circuit to form a whole circuit, which is capable of high efficient operation.
(2) The conductive circuit is fused with the glass substrate without any bonding medium so that the conductive circuit has the characteristic of good thermal conductivity in high-power applications. The conductive circuit is tightly fused with surface molecules of the glass substrate, wherein the solar chip can be bonded on the conductive circuit and the solar chip is not easily peeled off.
(3) The graphene powder accounts for 2% to 5% by mass of the conductive paste. Although the content of the graphene in the conductive paste is very little, the arrangement of molecules of the graphene are extremely dense, molecules of the graphene are light to enable to float on the surface of metal molecules, wear resistance of the graphene is higher than wear resistance of metal, and the graphene has high conductivity. Thus, the conductive circuit has still high conductivity. The graphene is almost transparent so that the highly conductive transparent glass-based circuit board has high light transmittance of more than 90%.
(4) The surface of the glass substrate and the upper surface of the conductive circuit are at the same level. Because a surface of the highly conductive transparent glass-based circuit board is smooth, the conductive circuit is not easily damaged.
(5) The conductive circuit is coated with the printed-circuit-board (PCB) organic solder-resistant layer, wherein the surface of the conductive circuit, except the region reserved for the solder pad used for welding the solar chip, is covered with the printed-circuit-board (PCB) organic solder-resistant layer. This coated process of the present invention is named for the second coated process. The second coated process is used for protecting the conductive circuit and preventing oxidation of the surface of the conductive circuit so as to maintain the ability of superconductivity.
(6) The conductive circuit of the present invention is totally fused with the glass substrate. If the high-conductivity and high-voltage solar photovoltaic glass panel is broken, the conductive circuit is disconnected and no voltage is formed because of the glass substrate being nonconductive. Thus, the high-conductivity and high-voltage solar photovoltaic glass panel can pass the safety regulations and is suitable for high-voltage and high-power applications, which only needs to convert direct current into alternating current and directly output the alternating current to the high-voltage power grid. The solar photovoltaic glass plate of the prior art is not easy to pass the safety regulations and can only be used at low voltage. If it is required to connect with the high-voltage power grid, it is necessary to convert the low voltage into the high-voltage alternating current.
(7) The solar chip is welded on the highly conductive transparent glass-based circuit board with high light transmittance through a reflow soldering technique. After melting the low temperature solder paste, the low temperature solder paste is formed to be a tin layer. The solar chip can be electrically connected with the conductive circuit through the tin layer. Through the design of the solar chips and the layout of the conductive circuits, for example, the reduction of the area of the solar chip and the sparse arrangement of the solar chips, the high-conductivity and high-voltage solar photovoltaic glass panel also has high light transmittance, which can be applied to the use of large-area light transmission, such as t the agricultural shed roofs. The application of the high-conductivity and high-voltage solar photovoltaic glass panel is wider than that of the solar photovoltaic glass panel of the prior art.

### BRIEF DESCRIPTION OF THE DRAWINGS

FIG. 1 is a schematic view showing the structure of a high-conductivity and high-voltage solar photovoltaic glass panel according to the present invention.
FIG. 2 is a cross sectional view taken along line A-A of FIG. 1.

In the figures, numeral 1 represents glass substrate; numeral 2 represents conductive circuit; numeral 3 represents solder pad; numeral 4 represents tin layer; numeral 5 represents graphene upper portion; numeral 6 represents metal lower portion; numeral 7 represents solar chip; and numeral 8 represents sealant.

### PREFERRED EMBODIMENTS OF THE INVENTION

The present invention will be further described below in conjunction with accompanying drawings and exemplary embodiments.

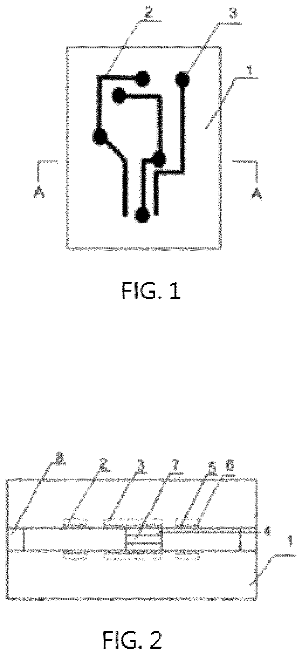

Please refer to FIGS. 1 to 2. The present invention provides a high-conductivity and high-voltage solar photovoltaic glass panel. The high-conductivity and high-voltage solar photovoltaic glass panel includes two glass substrates 1. A surface of each of the two glass substrates 1 faces air, i.e. the surface faces an air layer inside the high-conductivity and high-voltage solar photovoltaic glass panel. A conductive paste, printed on the surface of the glass substrate 1, is baked, heated, and cooled to form a conductive circuit 2 fused with the surface of the glass substrate 1. The conductive circuit 2 is a made essentially of a graphene layer or a conductive layer. The conductive layer has a graphene upper portion 5 and a metal lower portion 6 fused with the glass substrate 1, and a surface of the graphene upper portion 5 is fused with a surface of the metal lower portion 6. The surface of the glass substrate 1 and an upper surface of the conductive circuit 2 are at the same level. A solar chip 7 with two electrodes, respectively located on both sides of the solar chip 7, is clamped between the two glass substrates 1, and the two electrodes of the solar chip 7 are respectively connected with two solder pads 3 of the two conductive circuits 2 of the two glass substrates 1 through two tin layers 4. A sealant 8 is placed between the edges of the two glass substrates 1.

The surface of the glass substrate 1 and an upper surface of the conductive circuit 2 are at the same level.

A gap between the two glass substrates 1 is less than 2 mm.

The glass substrate 1 is a glass-tempered substrate.

The conductive paste includes conductive powder, low temperature glass powder, ethyl cellulose, terpineol, and dibutyl maleate. A mass ratio of conductive powder : low temperature glass powder : ethyl cellulose : terpineol: dibutyl maleate is 65 to 75 : 3 : 5 to 10 : 10 to 20 : 1 to 3. The conductive powder is graphene powder or a mixture of metal powder and graphene powder. When the conductive powder is the mixture of metal powder and graphene powder, the graphene powder accounts for 2% to 5% by mass of the conductive paste.

The surface of the glass substrate 1 faces air, and the conductive paste, printed on the surface of the glass substrate 1, is baked at a temperature between 120 and 150 °C for 100 to 200 seconds, placed at a temperature between 550 and 600 °C for 300 to 360 seconds, then placed at a temperature between 710 and 730 °C for 120 to 220 seconds, and finally cooled to form the conductive circuit 2 fused with the surface of the glass substrate 1.

The manufacturing process of the high-conductivity and high-voltage solar photovoltaic glass panel is described as follows:
Step (1): To manufacture a highly conductive transparent glass-based circuit board by the following steps:
   Step (a) is to print the conductive paste on the surface of the glass substrate 1, wherein the surface of the glass substrate 1 faces air. The conductive paste includes conductive powder, low temperature glass powder, ethyl cellulose, terpineol, and dibutyl maleate. A mass ratio of conductive powder : low temperature glass powder : ethyl cellulose : terpineol: dibutyl maleate is 65 to 75 : 3 : 5 to 10 : 10 to 20 : 1 to 3. The conductive powder is the graphene powder or the mixture of metal powder and graphene powder. When the conductive powder is the mixture of metal powder and graphene powder, the graphene powder accounts for 2% to 5% by mass of the conductive paste.
   Step (b) is to bake the glass substrate 1, covered with the conductive paste, at a temperature between 120 and 150 °C for 100 to 200 seconds.
   Step (c) is to place the glass substrate 1 at a temperature between 550 and 600 °C for 300 to 360 seconds, then to place at a temperature between 710 and 730 °C for 120 to 220 seconds, and finally to cool to room temperature to form the conductive circuit 2 distributed on the surface of the glass substrate 1 and fused with the surface of the glass substrate 1, wherein the conductive circuit 2 is to form a part of the glass substrate 1, and the glass substrate 1 is the glass-tempered substrate.
Step (2): To take the two highly conductive transparent glass-based circuit boards and to apply a low temperature solder paste along the conductive circuits 2 of the two highly conductive transparent glass-based circuit boards.
Step (3): To take the solar chip 7 with the two electrodes. A positive electrode and negative electrode are respectively located on the front side and the back side of the solar chip 7. The solar chip 7 is clamped between the two highly conductive transparent glass-based circuit boards, wherein the positive electrode of the solar chip 7 is contact with the low temperature solder paste coating on the conductive circuit 2 and the glass substrate 1 of the highly conductive transparent glass-based circuit board, and the negative electrode of the solar chip 7 is contact with the low temperature solder paste coating on the conductive circuit 2 and the glass substrate 1 of the other highly conductive transparent glass-based circuit board.
Step (4): To use a reflow soldering technique to heat the conductive circuit 2, so as to melt the low temperature solder paste.
Step (5): To seal the edges of the two highly conductive transparent glass-based circuit boards through a sealant 8.

The conductive circuit 2 of the present invention is totally fused with the glass substrate 1. If the high-conductivity and high-voltage solar photovoltaic glass panel is broken, the conductive circuit 2 is disconnected and no voltage is formed because of the glass substrate 1 being nonconductive. Thus, the high-conductivity and high-voltage solar photovoltaic glass panel can pass the safety regulations and is suitable for high-voltage and high-power applications, which only needs to convert direct current into alternating current and directly output the alternating current to the high-voltage power grid. The solar photovoltaic glass plate of the prior art is not easy to pass the safety regulations and can only be used at low voltage. If it is required to connect with a high-voltage power grid, it is necessary to convert the low voltage into the high-voltage alternating current. The solar chip 7 is welded on the highly conductive transparent glass-based circuit board with high light transmittance through the reflow soldering technique. After melting the low temperature solder paste, the low temperature solder paste is formed to be a tin layer 4. The solar chip 7 can be electrically connected with the conductive circuit 2 through the tin layer 4. Through the design of the solar chips and the layout of the conductive circuits, for example, the reduction of the area of the solar chip and the sparse arrangement of the solar chips, the high-conductivity and high-voltage solar photovoltaic glass panel also has high light transmittance, which can be applied to the use of large-area light transmission, such as t the agricultural shed roofs. The application of the high-conductivity and high-voltage solar photovoltaic glass panel is wider than that of the solar photovoltaic glass panel of the prior art.

## Claims

1. A high-conductivity and high-voltage solar photovoltaic glass panel, comprising glass substrates (1), **characterized in that**:
the glass substrates (1) have two glass substrates (1),
wherein a surface of each of the two glass substrates (1) faces air, and a conductive paste, printed on the surface of the glass substrate (1), is baked, heated, and cooled to form a conductive circuit (2) fused with the surface of the glass substrate (1);
wherein the conductive circuit (2) is made essentially of a graphene layer or a conductive layer having a graphene upper portion (5) and a metal lower portion (6) fused with the glass substrate (1), and a surface of the graphene upper portion (5) is fused with a surface of the metal lower portion (6);
wherein a solar chip (7) with two electrodes, respectively located on both sides of the solar chip (7), is clamped between the two glass substrates (1), the two electrodes of the solar chip (7) are respectively connected with two solder pads (3) of the two conductive circuits (2) of the two glass substrates (1) through two tin layers (4), and a sealant (8) is placed between the edges of the two glass substrates (1);
wherein the glass substrate (1) is a glass-tempered substrate, and a surface of the conductive circuit (2), except a region reserved for the solder pad (3) used for welding the solar chip (7), is covered with a printed-circuit-board organic solder-resistant layer;
wherein the conductive paste includes conductive powder, low temperature glass powder, ethyl cellulose, terpineol, and dibutyl maleate at a mass ratio of 65 to 75 : 3 : 5 to 10 : 10 to 20 : 1 to 3, and the conductive powder is graphene powder or a mixture of metal powder and graphene powder; and
wherein, when the conductive powder is the mixture of metal powder and graphene powder, the graphene powder accounts for 2% to 5% by mass of the conductive paste.

2. The high-conductivity and high-voltage solar photovoltaic glass panel of claim 1, **characterized in that** the surface of the glass substrate (1) and an upper surface of the conductive circuit (2) are at the same level.

3. The high-conductivity and high-voltage solar photovoltaic glass panel of claim 1, **characterized in that** a gap between the two glass substrates (1) is less than 2 mm.

4. The high-conductivity and high-voltage solar photovoltaic glass panel of claim 1, **characterized in that** the surface of the glass substrate (1) faces air, and the conductive paste, printed on the surface of the glass substrate (1), is baked at a temperature between 120 and 150 °C for 100 to 200 seconds, placed at a temperature between 550 and 600 °C for 300 to 360 seconds, then placed at a temperature between 710 and 730 °C for 120 to 220 seconds, and finally cooled to form the conductive circuit (2) fused with the surface of the glass substrate (1).
